Europäisches Patentamt

European Patent Office

Office européen des brevets

(11) Publication number: **0 323 183**

**A2**

## EUROPEAN PATENT APPLICATION

(21) Application number: 88312284.8

(22) Date of filing: **23.12.88**

(51) Int. Cl.4 **H01L 27/14 , G06K 9/26**

The title of the invention has been amended (Guidelines for Examination in the EPO, A-III, 7.3).

(30) Priority: **29.12.87 JP 332504/87**

(43) Date of publication of application: .
**05.07.89 Bulletin 89/27**

(84) Designated Contracting States:
**DE FR GB**

(71) Applicant: **SEIKO INSTRUMENTS INC.**
**31-1, Kameido 6-chome Koto-ku**
**Tokyo 136(JP)**

(72) Inventor: **Kawahara, Yukito**
**SEIKO INSTRUMENTS INC.**
**31-1 Kameido 6-chome Koto-ku Tokyo(JP)**
Inventor: **Machida, Satoshi**
**SEIKO INSTRUMENTS INC.**
**31-1 Kameido 6-chome Koto-ku Tokyo(JP)**
Inventor: **Mukainakano, Hiroshi**
**SEIKO INSTRUMENTS INC.**
**31-1 Kameido 6-chome Koto-ku Tokyo(JP)**
Inventor: **Higashi, Masato**
**SEIKO INSTRUMENTS INC.**
**31-1 Kameido 6-chome Koto-ku Tokyo(JP)**

(74) Representative: **Caro, William Egerton et al**
**J. MILLER & CO. Lincoln House 296-302 High**
**Holborn**
**London WC1V 7JH(GB)**

(54) **Integrated circuit with photo sensor cells.**

(57) A semi-conductor device comprises a plurality of photo-sensor cells $(2_1, 2_2...2_n)$ for reading image data, drive means $(16_1, 16_2...16_n)$ for driving printing cells in printing means, and control means $(11_1, 11_2...11_n, 12_1, 12_2...12_n, 13_1, 13_2...13_n, 14_1, 14_2...14_n$ and $15_1, 15_2...15_n)$ for controlling the drive means in response to received printing data and for processing output signals from the photo-sensor cells. The photo-sensor cells, the drive means and the control means are formed on a single substrate (3) as integrated circuits.

F I G. 2

# SEMI-CONDUCTOR DEVICE

The present invention relates to a semi-conductor device suitable for use in apparatus providing input output functions for characters and graphics, such as facsimile apparatus and a word processor.

Information processing apparatus providing the functions of reading characters and graphic information as image data and then printing out such data has been put into practical use both in the form of facsimile apparatus (hereinafter referred to as a fax machine) and in the form of a word processor. Such apparatus usually comprises photo-sensors for converting image data into electrical signals. logic circuits for processing and controlling the output signals of the photo-sensors, printing cells for printing given printing data onto a predetermined recording medium and drive circuits for driving the printing cells in accordance with the printing data, but each of these hardware elements is formed separately and they are subsequently built into a case.

With the extensive employment of such apparatus, attention is now focussed on realising smaller and lower cost components.

It is an object of the present invention to provide a device, suitable for use in a fax machine and a word processor for example, which enables reductions both in the size and the cost of such apparatus to be realised.

In accordance with the present invention, a device comprises a plurality of photo-sensor cells for reading image data, drive means for driving printing cells in printing means, and control means for controlling the drive means in response to received printing data and for processing output signals from the photo-sensor cells, characterised in that the device is a semi-conductor device, in which the photo-sensor cells, the drive means and the control means are formed on a single substrate as integrated circuits.

Thus, by means of a semi-conductor device having a single substrate, the image data may be converted into electrical data by the photo-sensor cells, and the converted data may be processed and supplied to external circuits. In addition, the semi-conductor device is adapted to be responsive to the printing data for controlling printing by driving a printing device such as a thermal printing head through the drive means.

The invention will be described further, by way of example, with reference to the accompanying drawings, in which:-

Figure 1 is a schematic diagram of an image sensor embodying the present invention;

Figure 2 is a circuit diagram showing the structure of a unit block of the sensor illustrated in Figure 1; and

Figure 3 is a perspective view of a thermal printing head in which the image sensor illustrated in Figure 1 is mounted.

According to the present invention. a semi-conductor device comprises, as an integrated circuit on a single substrate. a plurality of photo-sensor cells for reading image data such as characters and figures, a plurality of drive cells for driving respectively a plurality of printing cells to print determined images, and control circuits for controlling the photo-sensor cells and the drive cells.

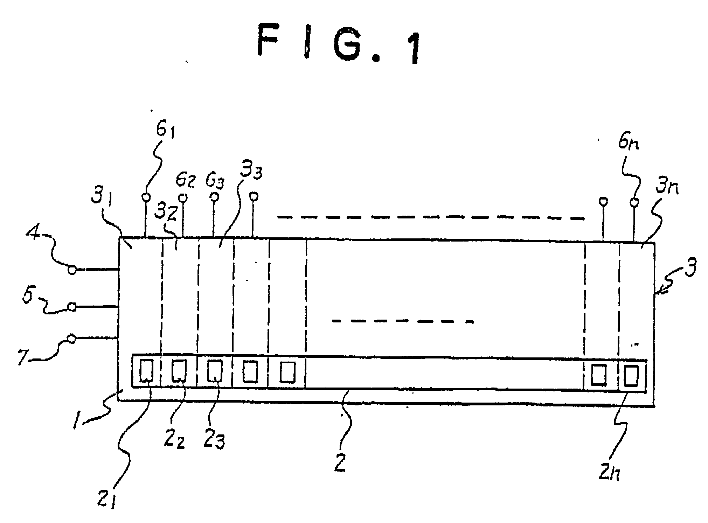

Figure 1 shows a semi-conductor device according to the present invention applied to an image sensor 1 of a fax machine or similar apparatus.

The image sensor 1 comprises an n-bit line image sensor 2 forming a part of an integrated circuit semi-conductor device having a single semi-conductor substrate 3. Photo-sensor cells $(2_1, 2_2...2_n)$ forming the line image sensor 2 are respectively arranged within unit blocks $3_1, 3_2...3_n$ arranged to form lines on the semi-conductor substrate 3.

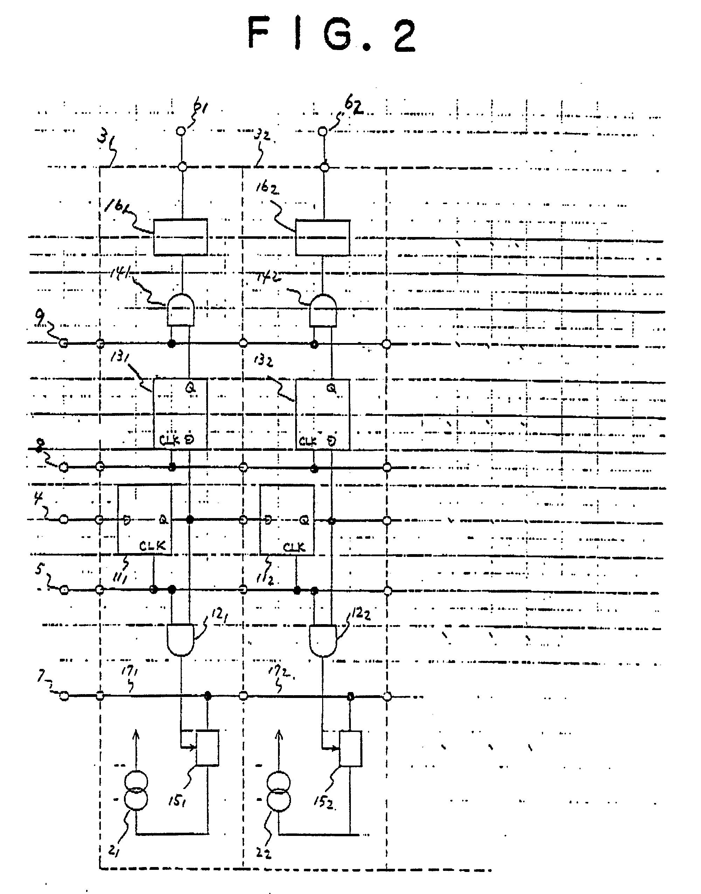

The unit blocks $3_1, 3_2...3_n$ have almost the same structure and therefore only the unit blocks $3_1, 3_2$ are shown in Figure 2 in detail.

Referring to Figure 2, the circuit of each unit block, $3_1$ for example, is as follows. A Q output terminal of a D type flip-flop $11_1$ (hereinafter abbreviated as FF) is connected to a D input terminal of a latch circuit $13_1$, while an external latch terminal 8 is connected to a clock input terminal (CLK) of the latch circuit $13_1$. A Q output terminal of the latch circuit $13_1$ is connected to one input terminal of an enable gate $14_1$ and another input terminal of the enable gate $14_1$ is connected to an external enable terminal 9. An output terminal of the enable gate $14_1$ is connected to an input terminal of a drive cell $16_1$, while an output terminal of the drive cell $16_1$ is connected to an external drive output terminal $6_1$. The Q output terminal of the FF $11_1$ is also connected to one input terminal of an AND gate $12_1$. another input terminal of the AND gate $12_1$ being connected to a clock input terminal (CLK) of the FF $11_1$. An output terminal of the AND gate $12_1$ is connected to a control terminal of a transfer gate $15_1$ and an output terminal of the photo-sensor cell $2_1$ is connected to an input terminal of the transfer gate $15_1$. An output terminal of the transfer gate $15_1$ is connected to an external terminal 7 through a common output line $17_1$.

A plurality of such unit blocks are connected to form the circuit of the present invention. Namely, the FF $11_1$ is connected so that it corresponds to a single stage of a shift register. The D input of the FF $11_1$ of the unit block in the first stage is connected to a data input terminal 4. Moreover, the common output line $17_1$, $17_2...17_n$ of each unit block is connected so as to be at the same potential as the external terminal 7. The clock input terminal of each FF $11_1$, $11_2...11_n$ is connected to an external clock input terminal 5, while the clock input terminal of each latch circuit $13_1$, $13_2...13_n$ is connected to the latch strobe terminal 8 in common and the external enable terminal 9 is connected to one input terminal of each enable gate $14_1$, $14_2...14_n$ in common.

The drive cells $16_1$, $16_2...16_n$ thus form a drive circuit, which although not illustrated drives printing cells, for example in a thermal printing head, and the photo-sensor cells, $2_1$, $2_2...2_n$ thus form the line image sensor. The other circuits $11_1$, $11_2...11_n$; $12_1$, $12_2...12_n$; $13_1$, $13_2...13_n$; $14_1$, $14_2...14_n$; $15_1$, $15_2...15_n$ respectively form the control circuits.

The operation for driving the printing cells will now be explained. The printing data is synchronised with the clock signal of the shift register formed by the FFs $11_1$, $11_2...11_n$ connected to the data input terminal 4 and is transferred to each unit block in turn. The printing data transferred to each block appears at the Q output of the respective FF $11_i$, and application of a control signal "ON" to the latch strobe terminal 8 holds such data in order to supply the printing data from each block to the respective latch circuits. After the latch circuits receive the printing data, a control signal "OFF" is applied to the latch strobe terminal 8, establishing the condition to input the printing data to the FFs.

In the case where it is desired to drive an external printing cell, for example a heat generating cell in a thermal printing head, on the basis of the data received by the latch circuit $13_i$, a control signal "ON" is input to the enable terminal 9 in order to switch the enable gate $14_i$ into an ON condition and operate the drive cell $16_i$ to drive the heat generating cell through the drive output terminal $6_i$ connected to the output terminal of the drive cell $16_i$. By turning OFF the enable gate $14_i$ and the drive cell $16_i$, the driving of the heat generating cell can be terminated when printing is complete. New data can then be printed by repeating these operations.

Next, operation of the device functioning as the image sensor will be explained. First, the control operation for serially extracting the n-bit parallel data obtained by the line image sensor 2 as an analog signal from the terminal 7 will be explained. N-bit serial data (1000...0) is applied to the terminal 4, which is the data input terminal of the shift register, and is then sequentially read to each stage of the shift register in synchronisation with the clock signal by applying clock pulses continuously to the clock terminal 5. Thereby, the transfer gates $15_1$, $15_2...15_n$ are sequentially turned ON and the image data obtained by the photo-sensor cells $2_1$, $2_2...2_n$ is sequentially output from the output terminal 7. During operation of the image sensor, it is made certain that the "OFF" signal is applied continuously to both the latch strobe and the enable terminals 8, 9 so that the drive cells for printing are not turned on.

Thus, as described, the drive circuits for driving the printing cells and the control circuits for controlling the printing cells are structured on the same substrate, in addition to the image sensor 2, thereby realising a reduction in size. Moreover, since these components all comprise semi-conductor elements, they can be formed as an integrated circuit on a single crystal substrate, thus resulting in a cost reduction through a simplified manufacturing process and providing a low cost device having a small size.

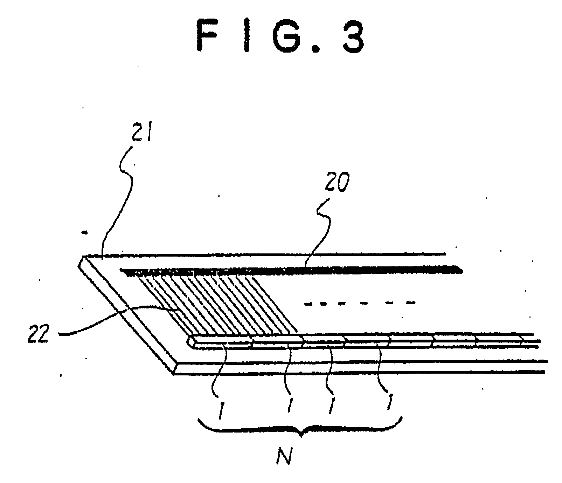

Figure 3 shows an example of the device in which N image sensors 1, of which one is illustrated in Figure 1, are provided in series on a ceramic substrate 21 carrying a heat generating cell array 20 for printing, and in which the drive output terminal $6_1$, $6_2...6_n$ of each image sensor 1 are connected to each heat generating cell of the heat generating array 20 by a group of wires 22 on a one to one basis.

In the case of this device, heat generated by the heat generating cell array 20 is transmitted to the image sensor 1, raising the temperature higher than the ambient temperature, but in the case where the image sensor does not supply only a binary output representing thick and thin as in an ordinary facsimile machine, problems do not occur even when photo-diodes which result in a heavy leak current under the high temperature condition are used in the image sensor. In the case where the thick and thin conditions of a document are read with output values of several levels to make a multi-level display, distinctive thick and thin images can be read with only an extremely small rise in dark output due to the temperature rise by employing floating base type photo-transistors. More over, a variety of elements may be used as the drive cell, an open drain type n-channel MOS transistor formed on a P type substrate being most suitable.

According to the present invention, circuit portions manufactured in the same semi-conductor integrated circuit process are formed on the same substrate as the image sensor. Thereby, not only can the size of the device be reduced, but also only a single manufacturing process is required. - Accordingly, the manufacturing cost can be reduced remarkably in comparison with the known manufacturing process, in which the circuit components are produced separately.

## Claims

1. A semi-conductor device comprising a plurality of photo-sensor cells ($2_1$, $2_2$...$2_n$) for reading image data, drive means ($16_1$, $16_2$...$16_n$) for driving printing cells in printing means, and control means ($11_1$...$11_n$, $12_1$...$12_n$, $13_1$...$13_n$, $14_1$...$14_n$, $15_1$...$15_n$ for controlling the drive means in response to received printing data and for processing output signals from the photo-sensor cells, characterised in that the device is a semi-conductor device, in which the photo-sensor cells, the drive means and the control means are formed on a single substrate (3) as integrated circuits.

2. A device as claimed in claim 1, characterised in that the plurality of photo-sensor cells form a line image sensor (2).

3. A thermal printing head characterised by a device as claimed in claim 1 or 2, and printing cells arranged to be driven by the drive means of the device.

# F I G. 1

# F I G. 2

# F I G . 3